(19) **Europäisches Patentamt European Patent Office Office européen des brevets**

(11) **EP 3 001 207 B1**

(12) **FASCICULE DE BREVET EUROPEEN**

(45) Date de publication et mention de la délivrance du brevet:
**06.11.2019 Bulletin 2019/45**

(51) Int Cl.:
*G01R 19/25* (2006.01)   *G01R 29/12* (2006.01)
*G01R 31/08* (2006.01)   *H04B 3/46* (2015.01)
*G01R 31/02* (2006.01)

(21) Numéro de dépôt: **15186784.3**

(22) Date de dépôt: **25.09.2015**

(54) **CAPTEUR DE TENSION, ENSEMBLE ET DÉTECTEUR DE DÉFAUT D'UN RÉSEAU ÉLECTRIQUE AÉRIEN COMPORTANT UN TEL CAPTEUR**

SPANNUNGSAUFNEHMER, GESAMTANORDNUNG UND FEHLERDETEKTOR EINES FREILEITUNGSNETZES, DAS EINEN SOLCHEN AUFNEHMER UMFASST

VOLTAGE SENSOR, ASSEMBLY AND FAULT DETECTOR OF AN OVERHEAD ELECTRICAL NETWORK COMPRISING SUCH A SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.09.2014 FR 1459145**

(43) Date de publication de la demande:
**30.03.2016 Bulletin 2016/13**

(73) Titulaire: **Schneider Electric Industries SAS 92500 Rueil-Malmaison (FR)**

(72) Inventeurs:
 • **SHI, Xiaodong**
  **38050 GRENOBLE Cedex 09 (FR)**
 • **HOUBRE, Pascal**
  **38050 GRENOBLE Cedex 09 (FR)**
 • **CONTINI, Erick**
  **38050 GRENOBLE Cedex 09 (FR)**
 • **COUTELOU, Olivier**
  **38050 GRENOBLE Cedex 09 (FR)**
 • **CLEMENCE, Michel**
  **38050 GRENOBLE Cedex 09 (FR)**

(74) Mandataire: **Lavoix 62, rue de Bonnel 69448 Lyon Cedex 03 (FR)**

(56) Documents cités:
**WO-A1-2013/158754    US-A1- 2008 246 507**

 • **WU L ET AL: "On-site voltage measurement with capacitive sensors on high voltage systems", 2011 IEEE TRONDHEIM POWERTECH : TRONDHEIM, NORWAY, 19 - 23 JUNE 2011, IEEE, PISCATAWAY, NJ, 19 juin 2011 (2011-06-19), pages 1-6, XP032263421, DOI: 10.1109/PTC.2011.6019197 ISBN: 978-1-4244-8419-5**

**Description**

La présente invention concerne un détecteur d'un défaut, par rapport, à la terre d'une phase d'un courant alternatif pour un réseau électrique aérien.

Dans le domaine des réseaux électriques aériens, une problématique est d'assurer un fonctionnement optimal du réseau et de réduire au minimum le nombre d'interruptions et de défauts du courant alternatif transmis sur le réseau. Lorsqu'une interruption intervient dans le réseau, il est nécessaire d'identifier et de localiser l'interruption afin de rétablir une alimentation électrique le plus vite possible. De plus, un inconvénient usuel est un défaut du phasage du courant transmis qui peut se produire le long d'une ligne de transmission du réseau.

A ce sujet, il est connu de fabriquer des capteurs de tensions rapport à la terre, d'une phase du courant alternatif. A titre d'exemple, on peut citer la thèse « Modelling and Performance Evaluation of a Three-phase Capacitive Voltage Sensor Topology » (S. Van der Merwe, H.J. Vermeulen. University of Stellenbosch). Ce document décrit un détecteur pour la mesure d'un module et d'une phase d'une tension transmise sur un réseau électrique aérien. Le détecteur est conçu pour être installé à la demande sous des conducteurs électriques du réseau tels que des lignes haute tension. Il comporte au moins trois capteurs différentiels chacun étant mis à un potentiel électrique flottant très proche de celui de la terre. Chaque capteur est alors considéré comme un diviseur capacitif de tension avec deux capacités à estimer pour réaliser la mesure de courant ou de tension. Des deux estimations la plus difficile est celle relative à la capacité entre le capteur et le conducteur correspondant du réseau électrique aérien. Cette capacité dépend de la position du capteur par rapport au conducteur, qui est sujet à une erreur humaine dans la mise en place du capteur ou à un déplacement du capteur et/ou du conducteur à cause des conditions météorologiques.

WO 2013/158754 A1 décrit un capteur de tension configuré pour surveiller une tension transmise par un conducteur d'une ligne de transmission aérienne.

US 2008/246507 A1 divulgue un dispositif configuré pour être rattaché à une ligne de transmission de haute tension et pour surveiller des paramètres de la tension transmise.

Le but de l'invention est donc de proposer un capteur permettant d'améliorer la mesure de la tension d'un conducteur du réseau aérien pour faciliter la détection d'un défaut éventuel.

A cet effet, l'invention a pour objet un détecteur d'un défaut, par rapport à la terre, d'une phase d'un courant alternatif pour un réseau électrique aérien, selon la revendication 1.

Grâce à l'invention, la plaque métallique de chaque capteur est à un potentiel électrique flottant très proche de celui du conducteur correspondant. Par conséquent, la seule des deux capacités du diviseur capacitif de tension qui est à estimer est la capacité entre la plaque métallique et la terre, l'autre capacité correspondant à la liaison électrique entre la plaque métallique et le conducteur. Cela simplifie la mesure de la tension du conducteur correspondant, notamment pour un réseau triphasé comportant une pluralité de conducteurs. La capacité entre la plaque métallique et la terre n'est en outre pas influencée par l'orientation de la plaque métallique par rapport à la terre, la terre étant considérée comme une surface infinie. Les erreurs sur les mesures sont alors sensiblement réduites. Ainsi, le niveau de signal obtenu pour les mesures est plus fort et moins bruité.

Selon des aspects avantageux mais non obligatoires de l'invention, le détecteur d'un défaut est selon l'une des revendications 2 à 10.

L'invention a également pour objet un procédé de détection d'un défaut, selon la revendication 11.

L'invention sera mieux comprise et d'autres avantages de celle-ci apparaitront plus clairement à la lumière de la description qui va suivre, donnée uniquement à titre d'exemple non limitatif et faite en référence aux dessins annexés, sur lesquels :

- la figure 1 est une représentation schématique d'un détecteur conforme à l'invention installé sur un réseau électrique aérien triphasé, le détecteur comprenant un ensemble de capteurs de mesure d'une grandeur électrique d'une phase correspondante du réseau aérien et un dispositif de détection du défaut en fonction de la ou des grandeurs mesurées ;
- la figure 2 est une représentation schématique de l'un des capteurs de mesure et du dispositif de détection de la figure 1 ;
- la figure 3 est un schéma équivalent de capacités associées à un capteur relié à l'un des conducteurs du réseau électrique aérien triphasé ;
- la figure 4 est un schéma analogue à celui de la figure 3 après une simplification ;
- la figure 5 est un schéma équivalent simplifié de capacités associées à l'ensemble des capteurs, chaque capteur étant relié à un conducteur respectif du réseau électrique aérien triphasé, et
- la figure 6 est un organigramme d'un procédé de détection d'un défaut conforme à l'invention.

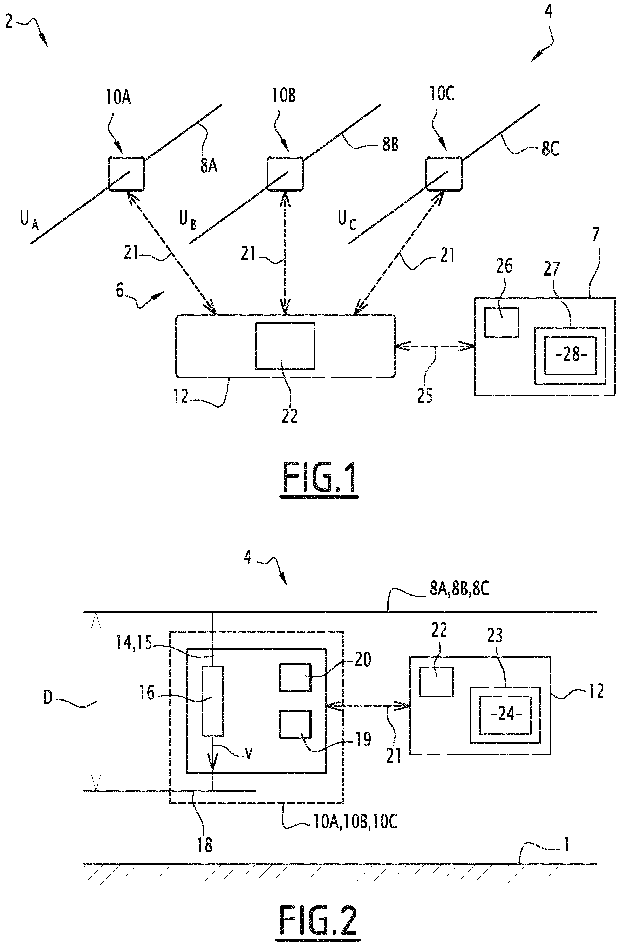

Sur la figure 1, un système électrique 2 est représenté schématiquement et comporte un réseau électrique aérien 4 et un détecteur 6 d'un défaut, par rapport à la terre 1, d'une phase P d'un courant alternatif parcourant le réseau 4.

Le système électrique comporte, en complément facultatif, un dispositif 7 de centralisation de données issues de plusieurs détecteurs 6.

Le réseau électrique aérien 4 comporte trois conducteurs électriques 8A, 8B et 8C. Chaque conducteur électrique 8A, 8B, 8C est configuré pour transmettre la phase P correspondante du courant alternatif. En particulier, un premier conducteur 8A transmet une première phase $P_A$, un deuxième conducteur 8B transmet une deuxième phase $P_B$ et un troisième conducteur 8C transmet une troisième phase $P_C$.

Le détecteur 6 connecté au réseau 4 comprend un ensemble de trois capteurs de mesure 10A, 10B, 10C, à savoir un premier capteur de mesure 10A, un deuxième capteur de mesure 10B et un troisième capteur de mesure 10C, chacun comprenant une plaque métallique 18 apte à être disposée entre le conducteur 8 et la terre 1. La plaque métallique 18 n'est pas reliée électriquement à la terre 1. En d'autres termes, cette plaque métallique 18 est électriquement flottante par rapport à la terre 1.

Le détecteur 6 comporte également un dispositif 12 de détection du défaut en fonction de grandeurs G mesurées par les capteurs 10A, 10B, 10C.

Le détecteur 6 comporte en outre des moyens 14 de liaison électrique de chaque plaque métallique 18 au conducteur électrique 8A, 8B, 8C correspondant.

Le détecteur 6 comporte également des moyens 15 de liaison mécanique du capteur de mesure 10A, 10B, 10C avec le conducteur électrique 8A, 8B, 8C correspondant. On note D la distance entre la plaque métallique 18 du capteur 10A, 10B, 10C et le conducteur électrique 8A, 8B, 8C correspondant. Les moyens de liaison mécanique 15 sont configurés pour que la distance D soit comprise entre 0 mm et 100 mm, de préférence sensiblement égale 50 mm.

Chaque capteur 10A, 10B, 10C est apte à mesurer la grandeur électrique G de la phase P du courant alternatif et est prévu pour chaque conducteur électrique 8A, 8B, 8C. La grandeur électrique G est déterminée en fonction d'une capacité C entre la plaque métallique 18 et la terre 1. La grandeur électrique G mesurée est par exemple la tension $U_A$, $U_B$, $U_C$ du conducteur électrique 8A, 8B, 8C correspondant, et chaque capteur de mesure 10 est alors un capteur de tension.

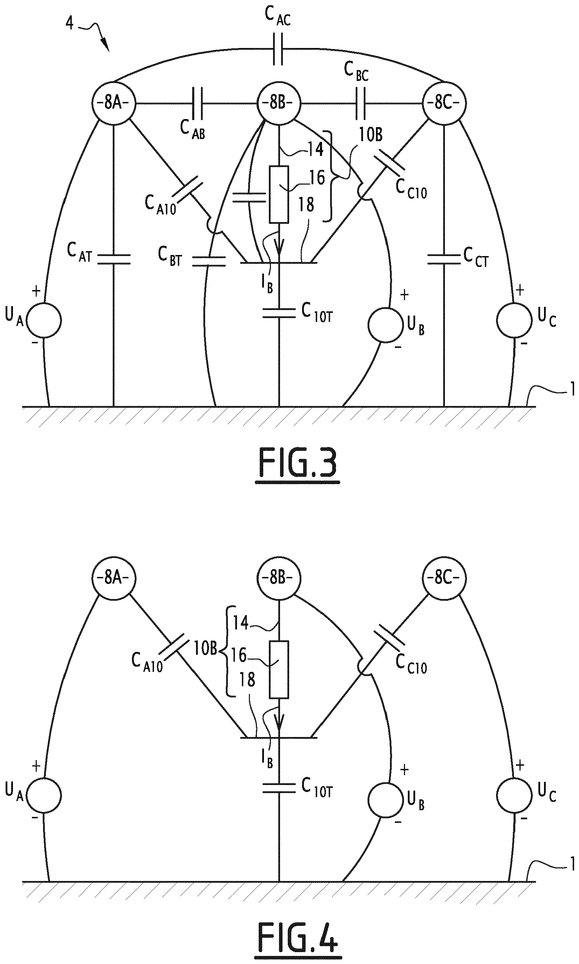

Chaque capteur 10A, 10B, 10C comprend en outre un organe 16 de mesure d'une variable électrique v associée aux moyens de liaison électrique 14. La grandeur électrique G est en outre déterminée en fonction de ladite variable électrique v mesurée. Dans l'exemple des figures 3 à 5, la variable électrique v mesurée est un courant I. En variante, la variable électrique v mesurée est déduite d'une mesure de tension V.

Chaque capteur de mesure 10A, 10B, 10C comporte une première unité de traitement d'informations 19 apte à transmettre, au dispositif de détection 12 et via un émetteur-récepteur 20, un signal radioélectrique S1 relatif à la grandeur mesurée G.

Le dispositif de détection 12 est configuré pour détecter les défauts en fonction de la ou des grandeurs électriques G mesurées par les capteurs de mesure 10A, 10B, 10C, et en complément, en fonction d'un ensemble de paramètres $E_P$ défini pour le réseau 4.

Le dispositif de détection 12 comporte un émetteur-récepteur 22 apte à communiquer avec l'émetteur-récepteur 20 de chaque capteur de mesure, et à recevoir les signaux radioélectriques S1 des capteurs de mesure 10A, 10B, 10C. Autrement dit, chaque capteur de mesure 10A, 10B, 10C et le dispositif de détection 12 sont reliés via une liaison radioélectrique 21.

Le dispositif 12 de détection comporte une deuxième unité de traitement d'informations 23, formée par exemple d'un processeur et d'une mémoire associée au processeur, non représentés, la mémoire étant apte à stocker un algorithme de détection 24, également appelée logiciel de détection, le processeur étant apte à exécuter l'algorithme de détection 24. L'algorithme de détection 24 est adapté pour détecter un défaut, par rapport à la terre 1, d'au moins une phase $P_A$, $P_B$, $P_C$ en fonction de la ou des grandeurs électriques G mesurées par le ou les capteurs de mesure 10. L'émetteur-récepteur 22 est configuré également pour transmettre un signal radioélectrique S2 au dispositif de centralisation 7 afin de signaler, le cas échéant, la détection d'un défaut.

Le dispositif de centralisation 7 comporte un émetteur-récepteur 26 apte à communiquer avec l'émetteur-récepteur 22 du dispositif de détection 12, et à recevoir notamment le signal S2 de la part du dispositif de détection 12. Autrement dit, le dispositif de détection 12 et le dispositif de centralisation 7 sont reliés via une liaison radioélectrique 25.

Le dispositif de centralisation 7 comporte une troisième unité de traitement d'informations 27, formée par exemple d'un processeur et d'une mémoire associée au processeur, non représentés, la mémoire étant apte à stocker un algorithme de correction 28, également appelée logiciel de correction, le processeur étant apte à exécuter l'algorithme de correction 28. L'algorithme de correction 28 est configuré pour déterminer la ou les corrections éventuelles à appliquer au courant alternatif du réseau aérien 4 en fonction du défaut détecté par le dispositif de détection 12.

La figure 3 représente un schéma équivalent de capacités associé au capteur 10B relié via les moyens de liaison électrique 14 au conducteur 8B du réseau électrique aérien 4 qui comporte en outre les conducteurs électriques 8A et 8C. La structure du réseau 4 induit des capacités parasites entre tous ces éléments. Lorsque le capteur 10B de mesure est mis en place dans le réseau 4, les valeurs de ces capacités sont constantes et l'ensemble de paramètre $E_P$ correspond à un ensemble de capacités $E_C$. Pour ce qui concerne ces capacités, on note $C_{AT}$ la capacité électrique entre le conducteur 8A et la terre 1. On note également $C_{BT}$ la capacité électrique entre le conducteur électrique 8B et la terre 1 et $C_{CT}$ la capacité électrique entre le conducteur électrique 8C et la terre 1. On note également $C_{AB}$, $C_{BC}$ et $C_{AC}$, les capacités électriques respectivement entre les conducteurs 8A et 8B, entre les conducteurs 8B et 8C et entre les conducteurs 8A et 8C. De plus, on note $C_{A10}$, $C_{B10}$ et $C_{C10}$, les capacités électriques entre la plaque métallique du capteur de mesure 10A, 10B, 10C correspondant et respectivement le conducteur 8A, le conducteur 8B et le conducteur 8C. Enfin, on note $C_{10T}$ la capacité électrique entre la plaque métallique du capteur de mesure 10A, 10B, 10C et la terre 1.

De plus, on note $U_A$ la différence de potentiel entre le premier conducteur 8A et la terre 1, qui correspond à la tension transmise par le premier conducteur 8A. De façon analogue, on note $U_B$ la différence de potentiel entre le deuxième conducteur 8B et la terre 1, qui correspond à la tension transmise par le deuxième conducteur 8B, et on note $U_C$ la différence de potentiel entre le troisième conducteur 8C et la terre 1, qui correspond à la tension transmise par le troisième conducteur 8C.

L'organe de mesure 16 inclus dans le deuxième capteur 10B est apte à mesurer un courant $I_B$, la variable mesurée étant alors le courant $I_B$. Le schéma équivalent de la figure 3 montre que le courant $I_B$ est fonction de la différence de potentiel $U_B$, de la différence de potentiel $U_A$ et de la différence de potentiel $U_C$ ainsi que de l'ensemble de capacités $E_C$. On a alors l'équation suivante :

$$I_B = f(E_C, U_A, U_B, U_C) \qquad\qquad (1)$$

Afin d'identifier le défaut, il est nécessaire d'estimer la phase $P_B$ du courant transmis dans le deuxième conducteur 8B, par exemple à partir de la tension $U_B$ qui doit donc être estimée. A partir de l'équation 1, la tension $U_B$ du deuxième conducteur est estimée en fonction du courant $I_B$, de l'ensemble de capacités $E_C$ ainsi que de la tension $U_A$ du premier conducteur et de la tension $U_C$ du troisième conducteur. On a donc l'équation suivante :

$$U_B = f(I_B, E_C, U_A, U_C) \qquad\qquad (2)$$

Sur le schéma équivalent de la figure 3, il est considéré que, pour la mesure du courant $I_B$, les capacités $C_{AB}$, $C_{BC}$, $C_{AC}$, ainsi que les capacités $C_{AT}$, $C_{BT}$ et $C_{CT}$ qui sont directement associées à une différence de potentiel parmi $U_A$, $U_B$ et $U_C$, sont négligeables. Selon cette simplification, ces capacités ne sont alors pas prises en compte pour la mesure de la grandeur G.

De plus, on note que la capacité $C_{B10}$ a une impédance électrique sensiblement supérieure à une résistance interne de l'organe de mesure 16 du deuxième capteur de mesure 10B, et son impact sur la mesure est alors négligeable. Selon cette simplification additionnelle, la capacité $C_{B10}$ n'est également pas prise en compte pour la mesure de la grandeur G.

Ceci permet alors de simplifier le schéma équivalent de la figure 3 et ainsi de simplifier l'estimation de la tension $U_B$ pour le deuxième conducteur 8B. La figure 4 montre le schéma équivalent simplifié, où sont représentées les seules capacités prises en compte pour la mesure du courant $I_B$, correspondant à la variable v mesurée, ces capacités définissant un ensemble réduit $E_C'$ de trois capacités.

L'application du théorème de Thévenin sur le schéma équivalent simplifié à la figure 4 permet de définir le courant $I_B$ comme le résultat d'une addition entre trois courants partiels $I_{BA}$, $I_{BB}$ et $I_{BC}$ distincts, chaque courant partiel $I_{BA}$, $I_{BB}$, $I_{BC}$ étant mesuré en prenant en compte, à chaque fois, une seule différence de potentiel parmi les différences de potentiel $U_A$, $U_B$, $U_C$. Chaque courant partiel $I_{BA}$, $I_{BB}$, $I_{BC}$ est alors fonction de la différence de potentiel correspondante et d'une ou plusieurs capacités électriques de l'ensemble $E_C$. On a alors l'équation suivante :

$$I_B = I_{BA} + I_{BB} + I_{BC} = -j\omega C_{A10}U_A + j\omega(C_{10T} + C_{A10} + C_{C10})U_B - j\omega C_{C10}U_A) \qquad (3)$$

En particulier, le courant partiel $I_{BA}$ est un produit entre la tension $U_A$ du premier conducteur et la capacité électrique $C_{A10}$. De façon analogue, le courant partiel $I_{BC}$ est un produit entre la tension $U_C$ du troisième conducteur et la capacité électrique $C_{C10}$. Enfin, le courant partiel $I_{BB}$ est un produit entre la tension $U_B$ du deuxième conducteur et une somme des capacités électriques $C_{10T}$, $C_{A10}$, $C_{C10}$.

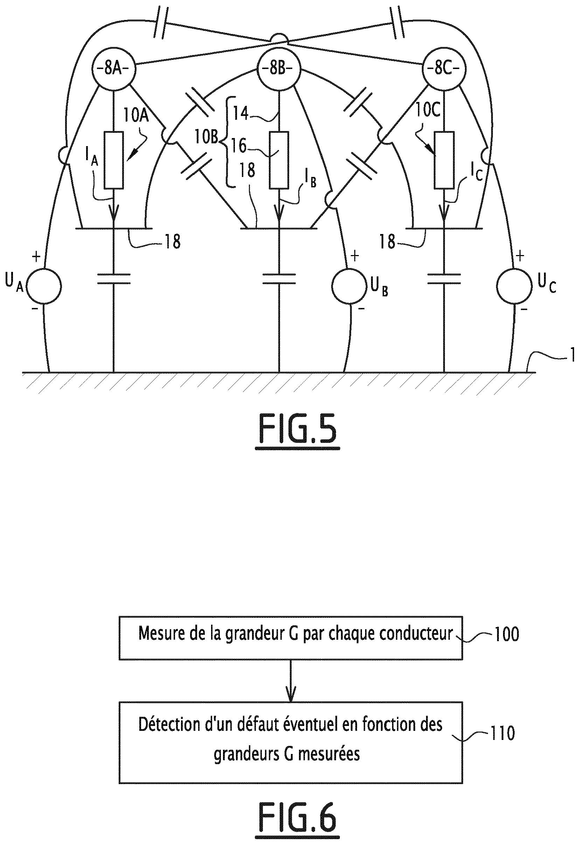

Afin d'estimer la tension $U_A$ du premier conducteur et la tension $U_C$ du troisième conducteur, pour résoudre l'équation (3), le premier capteur 10A et le troisième capteur 10C sont alors également pris en compte. Comme représenté à la figure 5, le schéma équivalent simplifié représente alors les trois capteurs de mesure 10A, 10B et 10C et un ensemble $E_C''$ de neuf capacités, un courant $I_A$ correspondant à la variable mesurée par le premier capteur 10A et un courant $I_C$ correspondant à la variable mesurée par le troisième capteur 10C.

De manière analogue, on détermine les phases $P_A$ et $P_C$ des tensions $U_A$ du premier conducteur et $U_C$ du troisième conducteur en écrivant les équations 1, 2 et 3 pour les courants $I_A$ et $I_C$. Les équations 3 pour les courants $I_A$, $I_B$ et $I_C$ sont alors écrites sous forme d'une seule équation matricielle, où un vecteur des courants mesurés $I_A$, $I_B$ et $I_C$ est estimé en fonction d'un produit entre une matrice C des capacités et un vecteur des tensions $U_A$, $U_B$ et $U_C$. On a alors l'équation suivante :

$$\begin{pmatrix} I_A \\ I_B \\ I_C \end{pmatrix} = j\omega \begin{pmatrix} C_{10T}{}^A + C_{B10}{}^A + C_{C10}{}^A & -C_{B10}{}^A & -C_{C10}{}^A \\ -C_{A10}{}^B & C_{10T}{}^B + C_{A10}{}^B + C_{C10}{}^B & -C_{C10}{}^B \\ -C_{A10}{}^C & -C_{B10}{}^C & C_{10T}{}^C + C_{A10}{}^C + C_{B10}{}^C \end{pmatrix} \cdot \begin{pmatrix} U_A \\ U_B \\ U_C \end{pmatrix} \qquad (4)$$

La matrice C comporte M lignes et N colonnes, où M est le nombre de capteurs de mesure 10A, 10B, 10C, et N est le nombre de conducteurs électriques 8A, 8B, 8C. Pour le réseau électrique aérien 4, qui comporte trois conducteurs électriques 8A, 8B, 8C et trois capteur de mesure 10A, 10B, 10C, la matrice C est carrée, les nombres M et N étant identiques, à savoir égaux à 3.

Les capacités électriques de la matrice C sont estimées en fonction de la position de chaque plaque métallique 18 par rapport aux conducteurs électriques 8A, 8B, 8C et à la terre 1 et en fonction d'une permittivité de l'atmosphère $\varepsilon_r$ présente autour de chaque capteur de mesure 10A, 10B, 10C. Puisque les capteurs de mesure 10A, 10B et 10C sont exposés à la même atmosphère, la permittivité $\varepsilon_r$ influence les capacités de la matrice C de la même manière et devient donc un paramètre négligeable pour la mesure de la grandeur G.

Les capacités sont ainsi estimées seulement en fonction de la position de chaque plaque métallique 18. En particulier, la capacité entre chaque plaque métallique 18 et la terre 1 est estimée en fonction de la distance entre ladite plaque 18 et la terre 1, et la capacité entre chaque plaque métallique 18 et le conducteur électrique 8A, 8B, 8C autre que celui qui est relié à la plaque métallique 18 correspondante est estimée en fonction de la distance entre ladite plaque 18 et ledit autre conducteur électrique 8A, 8B, 8C.

Les trois tensions $U_A$, $U_B$ et $U_C$ sont estimées en fonction de la matrice C et des courants $I_A$, $I_B$ et $I_C$, d'après l'équation suivante, obtenue à partir de l'équation (4) :

$$\begin{pmatrix} U_A \\ U_B \\ U_C \end{pmatrix} = \frac{1}{j\omega} [C]^{-1} \cdot \begin{pmatrix} I_A \\ I_B \\ I_C \end{pmatrix} \qquad (5)$$

La matrice C est une matrice non singulière, son déterminant étant non nul. Cela est dû au fait que la somme des coefficients de sa diagonale est sensiblement supérieure à la somme des coefficients qui ne sont pas sur la diagonale. La matrice C est donc facilement inversible, et cette inversion n'engendre pas d'erreur importante dans l'estimation des tensions $U_A$, $U_B$, $U_C$.

Dans l'exemple décrit, les courants $I_A$, $I_B$, $I_C$ et les tensions $U_A$, $U_B$, $U_C$ sont des signaux sinusoïdaux, le courant transmis par le réseau 4 étant un courant alternatif sinusoïdal. En complément facultatif, le réseau 4 transmet un courant non sinusoïdal et les courants $I_A$, $I_B$, $I_C$ et les tensions $U_A$, $U_B$, $U_C$ sont des signaux non sinusoïdaux.

L'équation (5) est alors généralisée par l'équation suivante :

$$\begin{pmatrix} U_A(t) \\ U_B(t) \\ U_C(t) \end{pmatrix} = \frac{1}{\varepsilon_r} \left[ C^{\varepsilon 0} \right]^{-1} \cdot \begin{pmatrix} \int_0^t I_{R_A}(t) \\ \int_0^t I_{R_B}(t) \\ \int_0^t I_{R_C}(t) \end{pmatrix} \qquad (6)$$

Le fonctionnement d'un procédé de détection d'un défaut selon l'invention va être à présent décrit.

Lorsque les conducteurs 8A, 8B, 8C du réseau électrique aérien 4 sont parcourus par le courant alternatif et lorsque chaque capteur de mesure 10A, 10B, 10C est relié électriquement à un conducteur électrique 8A, 8B, 8C respectif via les moyens 14 de liaison électrique, la grandeur électrique G est mesurée pour chacun des conducteurs 8A, 8B, 8C, lors d'une étape initiale 100.

La grandeur mesurée G est, par exemple, la tension $U_A$, $U_B$, $U_C$ de chacun des conducteurs 8A, 8B, 8C. Pour estimer la valeur de la grandeur G associée à chacun des conducteurs 8A, 8B, 8C, la variable électrique v associée aux moyens de liaison 14 est par exemple mesurée pour chacun desdits conducteurs. Dans l'exemple décrit, les courants $I_A$, $I_B$, $I_C$ circulant dans les moyens de liaison 14 sont alors mesurés pour estimer la valeur des tensions $U_A$, $U_B$, $U_C$ à l'aide de la matrice des capacités C.

Les valeurs des courants $I_A$, $I_B$, $I_C$ mesurés sont alors transmis par l'unité de traitement d'informations 19 et l'émetteur-récepteur 20 au dispositif de détection 12 via la liaison radioélectrique 21, et le dispositif de détection 12 estime alors les valeurs des tensions $U_A$, $U_B$, $U_C$ à l'aide de son unité de traitement d'informations 23, en fonction de la matrice C, qui est de préférence prédéterminée, et des valeurs des courants mesurés $I_A$, $I_B$, $I_C$ reçues de la part de chaque capteur de mesure 10A, 10B, 10C.

Lors d'une étape suivante 110, l'algorithme de détection 24 détecte un défaut éventuel et sa direction d'au moins une des phases $P_A$, $P_B$ et $P_C$ par rapport à la terre 1, à partir des valeurs estimées des tensions $U_A$, $U_B$, $U_C$.

**Revendications**

1. Détecteur (6) d'un défaut, par rapport à la terre (1), d'une phase ($P_A$, $P_B$, $P_C$) d'un courant alternatif pour un réseau électrique aérien (4), le réseau aérien comportant au moins deux conducteurs électriques (8A, 8B, 8C), chaque conducteur électrique étant adapté pour transmettre une phase correspondante du courant alternatif, le détecteur (6) comprenant :

   - un ensemble de capteurs (10A, 10B, 10C) de mesure d'une grandeur électrique d'une phase ($P_A$, $P_B$, $P_C$) correspondante, et
   - un dispositif de détection (12) du défaut en fonction de la ou des grandeurs électriques (G) mesurées,

   **caractérisé en ce que** chaque capteur de mesure (10A, 10B, 10C) comprend :

   + une plaque métallique (18) apte à être disposée entre le conducteur électrique (8A, 8B, 8C) et la terre (1), la grandeur électrique (G) étant déterminée en fonction d'une capacité entre la plaque métallique (18) et la terre (1), et
   + des moyens (14) de liaison électrique de la plaque métallique (18) au conducteur électrique (8A, 8B, 8C) correspondant,

   **en ce que** chaque capteur de mesure est destiné à être associé à un conducteur électrique (8A, 8B, 8C) respectif, et **en ce que** le dispositif de détection (12) est adapté pour détecter le défaut en fonction de chaque grandeur électrique (G) mesurée et d'un ensemble de paramètres ($E_P$) dépendant d'un ensemble de capacités électriques ($E_C$) relatives aux conducteurs électriques (8A, 8B, 8C).

2. Détecteur (6) selon la revendication 1, dans lequel chaque capteur (10A, 10B, 10C) comprend en outre un organe (16) de mesure d'une variable électrique ($I_A$, $I_B$, $I_C$) associée aux moyens de liaison (14), la grandeur électrique étant déterminée en fonction en outre de la variable électrique mesurée.

3. Détecteur (6) selon l'une des revendications précédentes, dans lequel la variable électrique ($I_A$, $I_B$, $I_C$) associée aux moyens de liaison (14) est un courant (I).

4. Détecteur (6) selon l'une quelconque des revendications précédentes, dans lequel chaque capteur de mesure (10A, 10B, 10C) est un capteur de tension, la grandeur électrique (G) mesurée étant une tension ($U_A$, $U_B$, $U_C$) du conducteur électrique (8A, 8B, 8C) respectif.

5. Détecteur (6) selon l'une quelconque des revendications précédentes, dans lequel les capacités électriques ($E_C$) sont estimées en fonction de la position de chaque plaque métallique (18) par rapport aux conducteurs électriques (8A, 8B, 8C) et à la terre (1), ainsi que de la permittivité ($\varepsilon_r$) de l'atmosphère autour de chaque plaque métallique (18).

6. Détecteur (6) selon l'une quelconque des revendications 1 à 4, dans lequel les capacités électriques sont estimées en fonction seulement de la position de chaque plaque métallique (18) par rapport aux conducteurs électriques (8A, 8B, 8C) et à la terre (1).

7. Détecteur (6) selon la revendication 6, dans lequel l'ensemble des capacités ($E_C$) comporte, pour chaque plaque métallique (18), seulement la capacité entre la plaque métallique (18) et la terre (1) et la capacité entre la plaque métallique (18) et chaque conducteur électrique (8A, 8B, 8C) autre que celui auquel la plaque métallique (18) correspondante est reliée électriquement.

8. Détecteur (6) selon la revendication 7, dans lequel chaque capacité est estimée en fonction de la distance entre la plaque métallique (18) et l'élément parmi la terre (1) et le conducteur électrique (8A, 8B, 8C) autre que celui auquel la plaque métallique (18) correspondante est reliée électriquement.

9. Détecteur (6) selon l'une des revendications précédentes, dans lequel l'ensemble des paramètres ($E_P$) est en forme d'une matrice (C) des capacités, la matrice (C) comportant M lignes et N colonnes, M étant les nombre de capteurs de mesure (10A, 10B, 10C) et N étant les nombre de conducteurs électriques (8A, 8B, 8C), la matrice (C) étant de préférence carrée et les nombres M et N étant égaux.

10. Détecteur (6) selon l'une des revendications précédentes, dans lequel le détecteur (6) comporte des moyens (15) de liaison mécanique de chaque capteur de mesure (10A, 10B, 10C) à un conducteur électrique respectif, les moyens (15) de liaison mécanique étant configurés pour que la distance entre ladite plaque métallique (18) et le conducteur (8A, 8B, 8C) correspondant soit comprise entre 0 mm et 100 mm, de préférence sensiblement égale 50 mm.

11. Procédé de détection, à l'aide d'un détecteur (6), d'un défaut, par rapport à la terre (1), d'une phase ($P_A$, $P_B$, $P_C$) d'un courant alternatif pour un réseau électrique aérien (4), le réseau aérien comportant au moins deux conducteurs électriques (8A, 8B, 8C), chaque conducteur électrique étant adapté pour transmettre la phase correspondante du courant alternatif, le procédé comprenant les étapes suivantes :

   - a) la mesure (100), via au moins un capteur de mesure (10A, 10B, 10C) du détecteur (6), d'une grandeur électrique (G) relative à au moins un conducteur électrique (8A, 8B, 8C), chaque capteur de mesure (10A, 10B, 10C) étant relié électriquement avec le conducteur électrique (8A, 8B, 8C) correspondant,
   - b) la détection (110) du défaut en fonction de la ou des grandeurs électriques mesurées,

   **caractérisé en ce que** le détecteur (6) est selon l'une des revendications précédentes.

## Patentansprüche

1. Detektor (6) eines Fehlers einer Phase ($P_A$, $P_B$, $P_C$) eines Wechselstroms in Bezug auf Erde (1) für ein elektrisches Freileitungsnetz (4), wobei das Freileitungsnetz mindestens zwei elektrische Leitungen (8A, 8B, 8C) aufweist und jede elektrische Leitung geeignet ist, eine entsprechende Phase des Wechselstroms zu übertragen, wobei der Detektor (6) umfasst:

   - eine Sensoranordnung (10A, 10B, 10C) zum Messen einer elektrischen Größe einer entsprechenden Phase ($P_A$, $P_B$, $P_C$) und
   - eine Vorrichtung (12) zum Erfassen eines Fehlers in Abhängigkeit von der oder den gemessenen elektrischen Größen (G),

   **dadurch gekennzeichnet, dass** jeder Meßsensor (10A, 10B, 10C) umfasst:

   + eine Metallplatte (18), die geeignet ist, zwischen der elektrischen Leitung (8A, 8B, 8C) und Erde (1) angeordnet zu werden, wobei die elektrische Größe (G) abhängig von einer Kapazität zwischen der Metallplatte (18) und Erde (1) bestimmt wird, und
   + Mittel (14) zum elektrischen Verbinden der Metallplatte (18) mit der entsprechenden elektrischen Leitung (8A, 8B, 8C),

   dass jeder Meßsensor vorgesehen ist, jeweils einer elektrischen Leitung (8A, 8B, 8C) zugeordnet zu werden und dass die Erfassungsvorrichtung (12) angepasst ist, den Fehler abhängig von jeder gemessenen elektrischen Größe (G) und einer Gesamtheit von Parametern ($E_P$), die von einer zu den elektrischen Leitungen (8A, 8B, 8C) gehörenden elektrischen Kapazitäten ($E_C$) abhängen, zu detektieren.

2. Detektor (6) nach Anspruch 1, bei dem jeder Sensor (10A, 10B, 10C) außerdem ein Element (16) zum Messen einer elektrischen Variablen ($I_A$, $I_B$, $I_C$) umfasst, die den Verbindungsmitteln (14) zugeordnet ist, wobei die elektrische Größe außerdem abhängig von der gemessenen elektrischen Variablen bestimmt wird.

3. Detektor (6) nach einem der vorhergehenden Ansprüche, bei dem die den Verbindungsmitteln (14) zugeordnete elektrische Variable ($I_A$, $I_B$, $I_C$) ein Strom (I) ist.

4. Detektor (6) nach einem beliebigen der vorhergehenden Ansprüche, bei dem jeder Sensor (10A, 10B, 10C) ein Spannungssensor ist, wobei die gemessene elektrische Größe (G) eine Spannung ($U_A$, $U_B$, $U_C$) der jeweiligen elektrischen Leitung (8A, 8B, 8C) ist.

5. Detektor (6) nach einem beliebigen der vorhergehenden Ansprüche, bei dem die elektrischen Kapazitäten (Ec) abhängig von der Position jeder Metallplatte (18) in Bezug auf die elektrischen Leitungen (8A, 8B, 8C) und Erde (1) sowie der Dielektrizitätskonstanten ($\varepsilon_r$) der Atmosphäre um jede Metallplatte (18) herum geschätzt werden.

6. Detektor (6) nach einem beliebigen der Ansprüche 1 bis 4, bei dem die elektrischen Kapazitäten nur abhängig von der Position jeder Metallplatte (18) in Bezug auf die elektrischen Leitungen (8A, 8B, 8C) und der Erde (1) geschätzt werden.

7. Detektor (6) nach Anspruch 6, bei dem die Gesamtheit der Kapazitäten (Ec) für jede Metallplatte (18) nur die Kapazität zwischen der Metallplatte (18) und Erde (1) und die Kapazität zwischen der Metallplatte (18) und jeder elektrischen Leitung (8A, 8B, 8C), die nicht diejenige ist, mit der die entsprechende Metallplatte (18) elektrisch verbunden ist, aufweist.

8. Detektor (6) nach Anspruch 7, bei dem jede Kapazität abhängig von dem Abstand zwischen der Metallplatte (18) und dem Element, ausgewählt aus Erde (1) und der elektrischen Leitung (8A, 8B, 8C), die nicht diejenige ist, mit der die entsprechende Metallplatte (18) elektrisch verbunden ist, geschätzt wird.

9. Detektor (6) nach einem der vorhergehenden Ansprüche, bei dem die Gesamtheit der Parameter ($E_P$) in Form einer Matrix (C) von Kapazitäten ausgebildet ist, wobei die Matrix (C) M Zeilen und N Spalten aufweist, wobei M die Anzahl an Meßsensoren (10A, 10B, 10C) ist und N die Anzahl an elektrischen Leitungen (8A, 8B, 8C) ist, wobei die Matrix (C) vorzugsweise quadratisch ist und die Anzahlen M und N gleich sind.

10. Detektor (6) nach einem der vorhergehenden Ansprüche, bei dem der Detektor (6) Mittel (15) zum mechanischen Verbinden jedes Meßsensors (10A, 10B, 10C) mit einer jeweiligen Leitung aufweist, wobei die Mittel (15) zum mechanischen Verbinden so ausgebildet sind, dass der Abstand zwischen der Metallplatte (18) und der entsprechenden Leitung (8A, 8B, 8C) zwischen 0 mm und 100 mm liegt, vorzugsweise im wesentlichen gleich 50 mm ist.

11. Verfahren zum Erfassen eines Fehlers einer Phase ($P_A$, $P_B$, $P_C$) eines Wechselstroms für ein elektrisches Freileitungsnetz (4) mithilfe eines Detektors (6), wobei das Freileitungsnetz mindestens zwei elektrische Leitungen (8A, 8B, 8C) aufweist und jede elektrische Leitung geeignet ist, eine entsprechende Phase des Wechselstroms zu übertragen, wobei das Verfahren die folgenden Schritte umfasst:

   - a) Messen (100) mittels mindestens eines Meßsensors (10A, 10B, 10C) des Detektors (6) einer elektrischen Größe (G) bezüglich mindestens einer elektrischen Leitung (8A, 8B, 8C), wobei jeder Meßsensor (10A, 10B, 10C) elektrisch mit der entsprechenden elektrischen Leitung verbunden ist und
   - b) Erfassen (110) des Fehlers in Abhängigkeit von der oder den gemessenen elektrischen Größen (G),

   **dadurch gekennzeichnet, dass** der Detektor (6) nach einem der vorhergehenden Ansprüche ausgebildet ist.

**Claims**

1. Detector (6) of a fault, relative to ground (1), of a phase ($P_A$, $P_B$, $P_C$) of an alternating current for an overhead electricity network (4), the overhead network having at least two electrical conductors (8A, 8B, 8C), each electrical conductor being adapted to transmit a corresponding phase of the alternating current, the detector (6) comprising:

   - a set of sensors (10A, 10B, 10C) for measuring an electrical quantity of a corresponding phase ($P_A$, $P_B$, $P_C$), and
   - a detection device (12) for detecting the fault as a function of the electrical quantities (G) measured,

**characterised in that** each measuring sensor (10A, 10B, 10C) comprises:

+ a metal plate (18) capable of being arranged between the electrical conductor (8A, 8B, 8C) and ground (1), the electrical quantity (G) being determined as a function of a capacitance between the metal plate (18) and ground (1), and
+ means (14) for electrically connecting the metal plate (18) to the corresponding electrical conductor (8A, 8B, 8C),

**in that** each measuring sensor is to be associated with a respective electrical conductor (8A, 8B, 8C), and
**in that** the detection device (12) is adapted to detect the fault as a function of each electrical quantity (G) measured and of a set of parameters ($E_P$) which are dependent on a set of electrical capacitances (Ec) relating to the electrical conductors (8A, 8B, 8C).

2. Detector (6) according to claim 1, wherein each sensor (10A, 10B, 10C) further comprises a member (16) for measuring an electrical variable ($I_A$, $I_B$, $I_C$) associated with the connecting means (14), the electrical quantity further being determined as a function of the measured electrical variable.

3. Detector (6) according to any one of the preceding claims, wherein the electrical variable ($I_A$, $I_B$, $I_C$) associated with the connecting means (14) is a current (I).

4. Detector (6) according to any one of the preceding claims, wherein each measuring sensor (10A, 10B, 10C) is a voltage sensor, the measured electrical quantity (G) being a voltage ($U_A$, $U_B$, $U_C$) of the respective electrical conductor (8A, 8B, 8C).

5. Detector (6) according to any one of the preceding claims, wherein the electrical capacitances (Ec) are estimated as a function of the position of each metal plate (18) relative to the electrical conductors (8A, 8B, 8C) and to ground (1), as well as of the permittivity ($\varepsilon_r$) of the atmosphere around each metal plate (18).

6. Detector (6) according to any one of claims 1 to 4, wherein the electrical capacitances are estimated as a function only of the position of each metal plate (18) relative to the electrical conductors (8A, 8B, 8C) and to ground (1).

7. Detector (6) according to claim 6, wherein the set of capacitances (Ec) comprises, for each metal plate (18), only the capacitance between the metal plate (18) and ground (1) and the capacitance between the metal plate (18) and each electrical conductor (8A, 8B, 8C) other than the one to which the corresponding metal plate (18) is electrically connected.

8. Detector (6) according to claim 7, wherein each capacitance is estimated as a function of the distance between the metal plate (18) and the element from among ground (1) and the electrical conductor (8A, 8B, 8C) other than the one to which the corresponding metal plate (18) is electrically connected.

9. Detector (6) according to any one of the preceding claims, wherein the set of parameters ($E_P$) is in the form of a matrix (C) of the capacitances, the matrix (C) having M rows and N columns, M being the number of measuring sensors (10A, 10B, 10C) and N being the number of electrical conductors (8A, 8B, 8C),
the matrix (C) preferably being square and the numbers M and N being equal.

10. Detector (6) according to any one of the preceding claims, wherein the detector (6) has means (15) for mechanically connecting each measuring sensor (10A, 10B, 10C) to a respective electrical conductor, the mechanical connection means (15) being configured so that the distance between said metal plate (18) and the corresponding conductor (8A, 8B, 8C) is between 0 mm and 100 mm, preferably substantially equal to 50 mm.

11. Method for detecting, by means of a detector (6), a fault, relative to ground (1), of a phase ($P_A$, $P_B$, $P_C$) of an alternating current for an overhead electricity network (4), the overhead network having at least two electrical conductors (8A, 8B, 8C), each electrical conductor being adapted to transmit the corresponding phase of the alternating current,
the method comprising the following steps:

- a) measuring (100), *via* at least one measuring sensor (10A, 10B, 10C) of the detector (6), an electrical quantity (G) relating to at least one electrical conductor (8A, 8B, 8C), each measuring sensor (10A, 10B, 10C) being electrically connected to the corresponding electrical conductor (8A, 8B, 8C),
- b) detecting (110) the fault as a function of the electrical quantity or quantities measured,

**characterised in that** the detector (6) is in accordance with any one of the preceding claims.

## FIG.1

## FIG.2

FIG.3

FIG.4

-8A-  -8B-  -8C-

10A  14  10C

10B  16

18

$I_A$  $I_B$  $I_C$

18  18

$U_A$ +  $U_B$ +  $U_C$ +
−  −  −

1

FIG.5

| Mesure de la grandeur G par chaque conducteur | ⌐100 |

| Détection d'un défaut éventuel en fonction des grandeurs G mesurées | ⌐110 |

FIG.6

**EP 3 001 207 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2013158754 A1

- US 2008246507 A1

**Littérature non-brevet citée dans la description**

- **S. VAN DER MERWE ; H.J. VERMEULEN.** Modelling and Performance Evaluation of a Three-phase Capacitive Voltage Sensor Topology. University of Stellenbosch